# EUROPEAN PATENT APPLICATION

(11) **EP 3 351 653 A1**
(43) Date of publication of application: **25.07.2018**
(21) Application number: 18152071.9
(22) Date of filing: 17.01.2018
(51) Int. Cl.: C23C 10/18, C23C 10/20, C23C 10/26, C23C 28/00

(54) **ALUMINIDE DIFFUSION COATING SYSTEM AND PROCESS FOR FORMING AN ALUMINIDE DIFFUSION COATING SYSTEM**

(30) Priority: 20.01.2017 IN 201741002288
(71) Applicant: General Electric Company, Schenectady, NY 12345 (US)
(72) Inventor: SRINIVASAN, Dheepa, 560066 Bangalore, Karnataka (IN); PRASAD, Raghupatruni, 560066 Bangalore, Karnataka (IN); DUVAL, Sophie Betty Claire, 5400 Baden (CH); GRASSO, Piero Daniele, 5400 Baden (CH); ARIF, Atifa, 17108 Dubai (AE)
(74) Representative: Foster, Christopher Michael

(57) **Abstract**

A process for forming an aluminide coating system (100) on a substrate (102). The process includes preparing a slurry including, by weight, about 35 to about 65% of an aluminum donor powder, the aluminum donor material comprising at least 35% aluminum, about 1 to about 25% of a binder, and balance essentially carrier. The slurry is applied to the substrate (102). The substrate (102) is a nickel or cobalt based superalloy being essentially free of aluminum. The slurry is heated to form an aluminide diffusion coating (100,106) including an additive aluminide layer (106,108) and an interdiffusion zone (108) disposed between the substrate (102) and the additive aluminide layer (106,108).

## Description

### FIELD OF THE INVENTION

The present invention is directed to an aluminide coating system and processes for forming an aluminide coating system. More particularly, the present invention is directed to a process for forming an aluminide diffusion coating on a nickel or cobalt based superalloy that is essentially free of aluminum.

### BACKGROUND OF THE INVENTION

Gas turbines include components, such as buckets (blades), nozzles (vanes), combustors, shrouds, and other hot gas path components which are coated with a thermal barrier coating to protect the components from the extreme temperatures, chemical environments and physical conditions found within the gas turbines. Aluminide coatings have been well known for a number of years and are widely used to protect metallic surfaces from oxidation and corrosion. In addition, aluminide coatings have been utilized as bond coatings for thermal barrier coating systems. One challenge relating to aluminide coatings is the limited substrates onto which an effective aluminide coating may be placed. For example, while cobalt based superalloys are desirable for use in gas turbine engine components due to their high oxidation and hot corrosion resistance at high temperatures, these alloys are difficult to coat with aluminide coatings. In particular, cobalt based superalloys having little or no aluminum have not been systems on which diffusion aluminide coatings could be enabled, owing to the formation of very brittle intermetallic phases.

### BRIEF DESCRIPTION OF THE INVENTION

In an exemplary embodiment, a process for forming an aluminide coating system on a substrate. The process includes preparing a slurry including, by weight, about 35 to about 65% of an aluminum donor powder, the aluminum donor material comprising at least 35% aluminum, about 1 to about 25% of a binder, and balance essentially carrier. The slurry is applied to the substrate. The substrate is a nickel or cobalt based superalloy without any aluminium or being essentially free of aluminum. The slurry is heated to form an aluminide diffusion coating including an additive aluminide layer and an interdiffusion zone disposed between the substrate and the additive aluminide layer.

In another exemplary embodiment, the present disclosure includes an aluminide coating system on a substrate. The coating system includes an aluminide diffusion coating disposed on the substrate. The substrate is a nickel or cobalt based superalloy that is essentially free of aluminum. The aluminide diffusion coating including an additive aluminide layer and an interdiffusion zone disposed between the substrate and the additive aluminide layer and is an inward-type diffusion coating.

Other features and advantages of the present invention will be apparent from the following more detailed description of the preferred embodiment, taken in conjunction with the accompanying drawings, which illustrate, by way of example, the principles of the invention.

### BRIEF DESCRIPTION OF THE DRAWINGS OF THE INVENTION

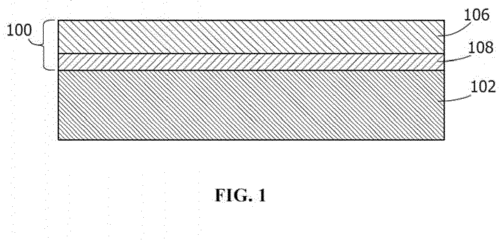

FIG. 1 is a schematic sectional view of a diffusion coating system, according to an embodiment of the present disclosure.

Wherever possible, the same reference numbers will be used throughout the drawings to represent the same parts.

### DETAILED DESCRIPTION

Provided are exemplary aluminide coating systems and methods for forming a diffusion coating system. Embodiments of the present disclosure, in comparison to methods not utilizing one or more features disclosed herein, provide a high oxidation resistance, a high ductility in the aluminide coating, little or no brittle cobalt silicide formation, or a combination thereof. In addition, the present disclosure permits the ability to form a relatively ductile coating system, including a 50 micron thick coating on an aluminum-free cobalt based alloy. The coating, accordingly to embodiments of the present disclosure, include a high aluminum content, including greater than 25 wt% or from about 25 wt% to about 45 wt% aluminum, which enables extended oxidation protection during service. The coating system, according to the present disclosure, permits resistance to hot corrosion on a hot gas path component that was otherwise not possible since, previously, these aluminum free alloy systems did not have aluminide coatings.

Referring to FIG. 1, in one embodiment, a diffusion coating system 100 on a substrate 102 includes an additive aluminide layer 106 and an interdiffusion zone 108 disposed between the substrate 102 and the additive aluminide layer 106. In a further embodiment, the aluminide diffusion coating 106 is an inward-type diffusion coating.

In one embodiment, the substrate 102 is a gas turbine component. The gas turbine component may be any suitable gas turbine component, including, but not limited to, a hot gas path component, a bucket (blade), a nozzle (vane), a shroud, a combustor, or a combination thereof.

In one embodiment, the substrate 102 includes a nickel-based superalloy, a cobalt-based superalloy, or a combination thereof. In one embodiment, the substrate 102 includes an alloy that is essentially free of aluminum. By "essentially free" it is meant that the concentration of aluminum in the alloy is less than about 0.1 wt% or less than about 0.05 wt% or less than about 0.01 wt%. In one embodiment, the substrate is formed from a CoCrMo alloy. In another embodiment, the substrate is formed from an alloy having a composition, by weight, of: about 10% nickel, about 29% chromium, about 7% tungsten, about 1% iron, about 0.25% carbon, about 0.01% boron, and balance cobalt (e.g., FSX414); about 0.015% boron, about 0.05% to about 0.15% carbon, about 20% to about 24% chromium, about 3% iron, about 0.02% to about 0.12% lanthanum, about 1.25% manganese, about 20% to about 24% nickel, about 0.2% to about 0.5% silicon, about 13% to about 15% tungsten, and balance cobalt (e.g., HAYNES® 188); about 22.5% to about 24.25% chromium, up to about 0.3% titanium (e.g., about 0.15% to about 0.3% titanium), about 6.5% to about 7.5% tungsten, about 9% to about 11% nickel, about 3% to about 4% tantalum, up to about 0.65% carbon (e.g., about 0.55% to about 0.65% carbon), about 2% to about 3% boron (e.g., about 2% to about 3% boron), about 1.3% iron, up to about 0.4% silicon, up to about 0.1% manganese, up to about 0.02% sulfur, and balance cobalt (e.g., MarM509); about 0.05% carbon, about 20% nickel, about 20% chromium, about 0.1% zirconium, about 7.5% tantalum, and balance cobalt (e.g., MarM918); about 5% iron, about 20% to about 23% chromium, up to about 0.5% silicon, about 8% to about 10% molybdenum, up to about 0.5% manganese, up to about 0.1% carbon, and balance nickel (e.g., IN625). Particularly suitable substrates including CoCrMo alloys that have been formed by direct metal laser melting (DMLM), alloys having a composition, by weight, of: about 10% nickel, about 29% chromium, about 7% tungsten, about 1% iron, about 0.25% carbon, about 0.01% boron, and balance cobalt (e.g., FSX414) that have been deposited by DMLM or direct metal laser sintering (DMLS) including γ-γ'cobalt alloys that contain Al. In one embodiment, the concentration of aluminum in the alloy is less than about 1.0 wt% or less than about 0.8 wt% or less than about 0.5 wt% or less than about 0.1 wt% or less than about 0.05 wt% or less than about 0.01 wt%.

In one embodiment, the additive aluminide layer 106 includes environmentally-resistant intermetallic phases, such as MAl, where M is iron, nickel or cobalt, depending on the substrate 102 material. The chemistry of the additive aluminide layer 106 may be modified by the addition of elements, such as chromium, silicon, platinum, rhodium, hafnium, yttrium, zirconium, or a combination thereof. Such modification may modify the environmental and physical properties of the additive aluminide layer 106. In one embodiment, the additive aluminide layer 106 includes a thickness of up to about 50 µm, alternatively up to about 75 µm, alternatively up to about 100 µm, alternatively between about 10 µm to about 25 µm, alternatively between about 25 µm to about 75 µm, alternatively between about 50 µm to about 100 µm

In one embodiment, the interdiffusion zone 108 includes a thickness of up to about 25 µm, alternatively up to about 15 µm, alternatively up to about 10 µm, alternatively between about 1 µm to about 25 µm, alternatively between about 5 µm to about 15 µm, alternatively between about 7 µm to about 10 µm. The interdiffusion zone 108 may include various intermetallic and metastable phases that form during the coating of the substrate 102 with the aluminide coating system 100. Without being bound by theory, it is believed that the various intermetallic and metastable phases form due to diffusional gradients and changes in elemental solubility in the local region of the substrate 102. The various intermetallic and metastable phases are distributed in a matrix of the substrate 102 material.

Exemplary diffusion coating system 100 thickness is in the range of about 50 µm to about 100 µm. In one embodiment, the interdiffusion zone 108 thickness is about 5 to about 10 µm on a Ni-base alloy containing Al (about 9.25% cobalt, about 9.5% tungsten, about 8.25% chromium, about 5.55% aluminum, about 0.25% silicon, about 0.1% manganese, about 0.075% carbon and balance nickel). In another embodiment, the total thickness diffusion coating system 100 thickness is in the range of about 60 µm with an interdiffusion zone 108 having a thickness of about 15 µm on a Co-based alloy (about 10% nickel, about 29% chromium, about 7% tungsten, about 1% iron, about 0.25% carbon, about 0.01 % boron, and balance cobalt).

In one embodiment, a process for forming an aluminide coating system 100 on a substrate 102 includes preparing a slurry including a donor powder, a binder, and a carrier, the donor powder including a metallic aluminum alloy.

In one embodiment, the donor material includes aluminum and silicon. In one embodiment, the donor material includes at least 35 wt% aluminum or at least about 40 wt% or from about 40 wt% to about 45 wt% aluminum or from about 42 wt% to about 44 wt% aluminum or up to about 50 wt% aluminum. Suitable donor materials include, but are not limited to, aluminum alloys, aluminum containing compounds and other aluminum donor materials. The donor material may include additive components. Suitable additive components for the donor material may include, but are not limited to, powder in elemental form selected from at least one of the group consisting of silicon, chromium, titanium, tantalum or boron.

The binder is a heat curable binder and may include any suitable binder material, such as inorganic salts. In one embodiment, the binder material includes at least 10 wt% inorganic salt or at least about 20 wt% or from about 10 wt% to about 50 wt% inorganic salt or from about 15 wt% to about 30 wt% inorganic salt or from about 20 wt% to about 25 wt% inorganic salt. Suitable binder materials include, but are not limited to, chromate compounds, phosphate compounds, molybdate compounds, tungstate compounds, and combinations thereof. Examples of binder components include phosphoric acid, chromic acid, and combinations thereof.

The carrier may include inorganic or organic carriers. Suitable carriers include, but are not limited to, water, toluene, acetone, and combinations thereof. In one embodiment, the carrier is free of gel material. In one embodiment, the slurry is free of inert fillers and inorganic carriers. The absence of inert fillers and inorganic carriers prevents such materials from sintering and becoming entrapped in the substrate 102.

Suitable slurry compositions for use with the present disclosure include a composition comprising less than about 20 wt% phosphoric acid, less than about 1 wt% chromic acid, less than or equal to 50 wt% aluminum powder and less than about 6 wt% silicon powder, and a balance water as carrier. Another suitable slurry composition includes about 35% aluminum powder, about 6% silicon powder, about 12% phosphate-chromate binder (binder salts), with a balance water as carrier.

The slurry is applied to the substrate and heated to dry and cure the slurry on the surface of substrate 102 and to leave a dried coating material. In one embodiment, the slurry includes, by weight, about 35 to about 65% of the donor powder, about 1 to about 25% of the binder, and balance essentially carrier. The applied slurry composition may include a non-uniform thickness with a minimum thickness of about 0.05 mm and a maximum thickness of about 1 mm or more, and the aluminide coating system 100 has a thickness which varies by about 0.01 mm or less, and is therefore essentially independent of the thickness of the slurry coating. The slurry coating may include a maximum thickness of about 1 mm. The slurry is applied to the surface of the substrate by any suitable technique. Suitable application techniques include spraying, rolling, dipping or brushing.

The drying step is preferably accomplished by heating the coating slurry to a drying temperature of from about 125° F to about 300° F (about 52 °C to about 149 °C) in air, for a time of from about 1 to about 4 hours. In addition, the coating is cured prior to diffusion treatment into a green-body by heating to a temperature from about 572° F to about 752° F (about 300 °C to about 400 °C) for a time of from about 1 to about 4 hours. In one embodiment, the applying, drying steps and curing steps may be repeated two times, three times, four times or more to provide a thicker dried coating.

The slurry coating that has been applied to the substrate, which may have been dried or not, is heated to form the aluminide diffusion coating 100. The coating chamber is evacuated, and may be backfilled with an inert or reducing atmosphere (such as argon or hydrogen, respectively). The slurry may be heated on the substrate to a temperature within a range of about 800 °C to about 900 °C or 825 °C to about 875 °C or 840 °C to about 860 °C. The temperature within the coating chamber is raised to a temperature sufficient to volatilize the slurry components, and aluminum is deposited on and into the substrate 102. The substrate 102 may be maintained at the diffusion temperature, for example, for a suitable duration, depending on the final thickness desired for the additive aluminide layer 106 and the interdiffusion zone 108. The heat treatment may include any suitable duration, including, but not limited to, a duration from about 1 to 8 hours, alternatively from about 2 hours to about 7 hours, alternatively from about 3 hours to about 6 hours, or alternatively from about 4 to about 5 hours or alternatively from about 1 to about 3 hours or alternatively from about 1.5 to about 2.5 hours. The heat treatment of the slurry may form a residue. The residue may be removed by any suitable technique, including, but not limited to, directing forced gas flow at the aluminide diffusion coating 100, grit blasting the aluminide diffusion coating 100, or a combination thereof. The temperature of the heat treatment is controlled to provide a temperature sufficiently low to provide an inward diffusion of the aluminum into the substrate. In addition, the heat treatment is controlled such that any Co-silicides that form are not brittle and so that the coating is compliant with desirable ductility. In one embodiment, the thickness ratio between dried and cured green-body and diffusion heat treated coating is about 3 to 1.

In one embodiment, the aluminide diffusion coating 100 includes an average content of from about 30 to about 38 wt% A1 and from about 6 to about 10 wt% Si is present in an upper half of the coating. In another embodiment, the aluminide diffusion coating 100 includes a silicon modified aluminum diffusion coating with a silicide (Cr/W/Ta) enriched layer at the outer surface.

An interdiffusion zone 108 forms between the substrate 102 and the additive aluminide layer 108 of the aluminide diffusion coating 100 and extends into the substrate, wherein the diffusion coating system 100 is an inward-type aluminide diffusion coating.

While not wishing to be bound by theory or explanation, the high aluminum concentration in the slurry and the heat treatment temperature being relatively low provides an inward diffusion, or high activity diffusion, with co-silicide formations that are not brittle. Inward diffusion of aluminum can result in a high aluminum concentration gradient in the coating. Likewise, the combination of the high aluminum and lower heat treatment temperature results in a compliant coating with high hardness.

The coating and method according to the present disclosure may allow deposition of internal aluminide coating onto internal surfaces of components. Internal aluminide coatings, as utilized herein, include aluminide coating present on the internal surfaces, such as the internal surface of hot gas path components having cooling holes, including radial, diffuser or serpentine cooling holes.

While the invention has been described with reference to a preferred embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

Various aspects and embodiments of the present invention are defined by the following clauses:
1. A process for forming an aluminide coating system on a substrate, the process comprising:
   preparing a slurry including, by weight, about 35% to about 65% of an aluminum donor powder, the aluminum donor material comprising at least 35% aluminum, about 1 to about 25% of a binder, and balance essentially carrier;
   applying the slurry to the substrate, the substrate being a nickel or cobalt based superalloy being essentially free of aluminum;
   heating the slurry to form an aluminide diffusion coating including an additive aluminide layer and an interdiffusion zone disposed between the substrate and the additive aluminide layer.
2. The process as in clause 1, wherein the donor powder includes an aluminum powder and an additive component.
3. The process as in clause 2, wherein the additive component is silicon powder.
4. The process as in clause 1, wherein the binder is selected from the group consisting of chromate compounds, phosphate compounds, molybdate compounds, tungstate compounds, and combinations thereof.
5. The process as in clause 1, wherein the binder is selected from the group consisting of chromic acid, phosphoric acid, and combinations thereof.
6. The process as in clause 1, wherein the slurry is heated on the substrate to a temperature within a range of about 800 °C to about 900 °C.
7. The process as in clause 1, wherein forming the aluminide diffusion coating includes forming the aluminide diffusion coating as an inward-type coating.
8. The process as in clause 1, wherein the aluminide diffusion coating is an internal aluminide coating.
9. The process as in clause 1, wherein the substrate is a gas turbine component.
10. The process as in clause 1, wherein the gas turbine component is selected from the group consisting of a bucket, a nozzle, a shroud, a combustor, a hot gas path component, and combinations thereof.
11. The process as in clause 1, wherein the substrate includes a nickel-based superalloy.
12. The process as in clause 1, wherein the substrate includes a cobalt-based superalloy.
13. The process as in clause 1, wherein the substrate includes a composition, by weight, of about 10% nickel, about 29% chromium, about 7% tungsten, about 1% iron, about 0.25% carbon, about 0.01 % boron, and balance cobalt.
14. The process as in clause 1, wherein the substrate includes less than 0.5 wt% aluminum.
15. The process as in clause 1, wherein the substrate includes less than 0.1 wt% aluminum.
16. The process as in clause 1, wherein the substrate includes less than 0.01 wt% aluminum.
17. An aluminide coating system on a substrate, comprising:
   an aluminide diffusion coating disposed on the substrate, the substrate being a nickel or cobalt based superalloy being essentially free of aluminum, the aluminide diffusion coating including an additive aluminide layer and an interdiffusion zone disposed between the substrate and the additive aluminide layer;
   wherein the aluminide coating includes an inward-type diffusion coating.
18. The aluminide coating system as in clause 17, wherein the substrate is a gas turbine component selected from the group consisting of a bucket, a nozzle, a shroud, a combustor, another hot gas path component, and combinations thereof.
19. The aluminide coating system as in clause 17, wherein the substrate includes a cobalt-based superalloy.
20. The aluminide coating system as in clause 19, wherein the substrate includes a concentration of aluminum less than about 0.1 wt%.

## Claims

1. A process for forming an aluminide coating system (100) on a substrate (102), the process comprising:
preparing a slurry including, by weight, 35% to 65% of an aluminum donor powder, the aluminum donor material comprising at least 35% aluminum, 1 to 25% of a binder, and balance essentially carrier;
applying the slurry to the substrate (102), the substrate (102) being a nickel or cobalt based superalloy being essentially free of aluminum;
heating the slurry to form an aluminide diffusion coating (100,106) including an additive aluminide layer (106,108) and an interdiffusion zone (108) disposed between the substrate (102) and the additive aluminide layer (106,108).

2. The process as claimed in claim 1, wherein the donor powder includes an aluminum powder and an additive component.

3. The process as claimed in claim 1 or claim 2, wherein the binder is selected from the group consisting of chromate compounds, phosphate compounds, molybdate compounds, tungstate compounds, and combinations thereof.

4. The process as claimed in any of preceding claims, wherein the binder is selected from the group consisting of chromic acid, phosphoric acid, and combinations thereof.

5. The process as claimed in any of preceding claims, wherein the slurry is heated on the substrate (102) to a temperature within a range of 800 °C to 900 °C.

6. The process as claimed in any of preceding claims, wherein forming the aluminide diffusion coating (100,106) includes forming the aluminide diffusion coating (100,106) as an inward-type coating.

7. The process as claimed in any of preceding claims, wherein the substrate (102) is a gas turbine component.

8. The process as claimed in any of preceding claims, wherein the gas turbine component is selected from the group consisting of a bucket, a nozzle, a shroud, a combustor, a hot gas path component, and combinations thereof.

9. The process as claimed in any of preceding claims, wherein the substrate (102) includes a nickel-based superalloy.

10. The process as claimed in any of preceding claims, wherein the substrate (102) includes a cobalt-based superalloy.

11. The process as claimed in any of preceding claims, wherein the substrate (102) includes a composition, by weight, of 10% nickel, 29% chromium, 7% tungsten, 1% iron, 0.25% carbon, 0.01% boron, and balance cobalt.

12. The process as claimed in any of preceding claims, wherein the substrate (102) includes less than 0.5 wt% aluminum.

13. An aluminide coating system (100) on a substrate (102), comprising:
an aluminide diffusion coating (100,106) disposed on the substrate (102), the substrate (102) being a nickel or cobalt based superalloy being essentially free of aluminum, the aluminide diffusion coating (100,106) including an additive aluminide layer (106,108) and an interdiffusion zone (108) disposed between the substrate (102) and the additive aluminide layer (106,108);
wherein the aluminide coating includes an inward-type diffusion coating.

14. The aluminide coating system (100) as claimed in claim 13, wherein the substrate (102) is a gas turbine component selected from the group consisting of a bucket, a nozzle, a shroud, a combustor, another hot gas path component, and combinations thereof.

15. The aluminide coating system (100) as claimed in claim 13 or claim 14, wherein the substrate (102) includes a cobalt-based superalloy.
